# EUROPÄISCHE PATENTSCHRIFT

(11) **EP 2 875 872 B1**
(45) Veröffentlichungstag und Bekanntmachung des Hinweises auf die Patenterteilung: **28.03.2018**
(21) Anmeldenummer: 13194261.7
(22) Anmeldetag: 25.11.2013
(51) Int. Cl.: B05C 9/06, G03F 7/00, G03F 7/12, C23F 1/00, B41M 7/00, B44C 1/00, B41M 1/20, B44C 1/22, B29C 33/38, B29C 45/37

(54) **Schablone für ätztechnische Oberflächenstrukturierungen**
Template for surface structures produced by etching
Gabarit destiné à des structurations de surface gravées

(43) Veröffentlichungstag der Anmeldung: 27.05.2015
(73) Patentinhaber: AKK GmbH, 47809 Krefeld (DE)
(72) Erfinder: Kesper, Peter, 47809 Krefeld (DE)
(74) Vertreter: Cohausz & Florack

(56) Entgegenhaltungen:
- EP-A2- 1 004 440
- WO-A1-2005/045098
- WO-A2-98/02924
- DE-A1- 2 133 230
- DE-A1-102006 022 722
- GB-A- 375 774
- JP-A- S57 169 090
- JP-A- S58 203 054
- US-A- 4 648 174
- US-A1- 2003 034 328
- US-A1- 2007 128 748
- US-A1- 2011 024 392
- US-A1- 2011 076 448
- US-A1- 2013 286 439

## Beschreibung

Die Erfindung betrifft eine Schablone für ätztechnische Oberflächenstrukturierungen, ein Verfahren zur Herstellung einer solchen Schablone, eine Druckmaschine zur Herstellung einer solchen Schablone sowie ein Verfahren zur ätztechnischen Oberflächenstrukturierung.

Aus dem Stand der Technik bekannte Schablonen für ätztechnische Oberflächenstrukturierungen weisen eine ätzresistente Schablonenschicht auf, wobei die Schablonenschicht, zum Beispiel durch Abreiben, auf die zu strukturierende Oberfläche übertragbar ist und wobei die Schablonenschicht nach einer ätztechnischen Behandlung der zu strukturierenden Oberfläche entfernbar ist.

Derartige Schablonen werden eingesetzt um auf Metalloberflächen, insbesondere Oberflächen von Spritzgusswerkzeugen, ein Strukturbild herzustellen, zum Beispiel die Nachbildung einer genarbten Lederoberfläche, welches beim anschließenden Spritzgießen auf die Oberfläche des spritzgegossenen Kunststoff-Teils übertragen wird.

Zu diesem Zweck wird eine ätzresistente Schablonenschicht - üblicherweise von einem Schablonenträger - auf die Metalloberfläche übertragen. Dieses geschieht regelmäßig dadurch, dass der zum Beispiel als Papier oder Folie ausgebildete Schablonenträger auf die zu strukturierende Oberfläche gelegt wird und die Schablonenschicht von dem Schablonenträger durch Abreiben, d.h. durch die Aufbringung von Druck auf den Schablonenträger in Richtung auf die zu strukturierende Oberfläche, übertragen wird. Hierbei handelt es sich üblicherweise um einen von Hand durchgeführten Vorgang, da die zu strukturierenden Oberflächen regelmäßig eine dreidimensionale Form haben, die eine maschinelle Übertragung der Schablonenschicht nicht zulässt oder zumindest stark erschwert.

Ist die Schablonenschicht auf die zu strukturierende Oberfläche übertragen worden, so bildet die Schablonenschicht nunmehr eine säurewiderstandsfähige Schicht, die bestimmte Bereiche der zu strukturierenden Oberfläche abdeckt. Setzt man nun das Werkstück, d.h. zum Beispiel die Spritzgussform, einem Säurebad aus, so führt die Reaktionsfähigkeit der nicht abgedeckten Oberfläche des Werkstücks dazu, dass mit Hilfe der durch die Säure ausgelöste Oxidation ein Materialabtrag erfolgt.

Derartige ätztechnische Oberflächenstrukturierungen sind weit verbreitet, da insbesondere die Oberfläche von spritzgegossenen Kunststoffteilen wesentlich das Gesamterscheinungsbild des Endproduktes prägen. Die Anforderungen an die mit der ätztechnischen Oberflächenstrukturierung erzielten Strukturbilder steigen dabei zunehmend. In vielen Fällen kann diesen nur genügt werden, indem die ätztechnische Oberflächenstrukturierung in mehreren Schritten erfolgt. Dabei ist Bestandteil jedes Schrittes die Übertragung einer Schablonenschicht auf die - ab dem zweiten Schritt - weiter zu strukturierende Oberfläche und eine anschließende weitere Behandlung in einem Säurebad. Mit den Anforderungen an das endgültige Strukturbild steigen auch die Anforderungen an den Übertrag der Schablonenschicht in einem zweiten oder weiteren Schritten. Der Aufwand für den üblicherweise händischen Übertrag einer Schablonenschicht auf eine bereits ätztechnisch strukturierte Oberfläche ist dabei erheblich.

Zur Herstellung einer Schablone für ätztechnische Oberflächenstrukturierungen ist es bekannt, ein Verfahren einzusetzen, bei welchem eine ätzresistente Schablonenschicht mit Hilfe eines Matrixdruckers auf einen Schablonenträger aufgebracht wird. Durch die Verwendung eines Matrixdruckers, d.h. eines Druckers, der sein Druckbild durch Setzen von einzelnen Bildpunkten erzeugt, ist es einfach möglich, die Schablonenschicht in nahezu beliebiger Gestaltung herzustellen.

Bekannte Druckmaschinen zur Herstellung einer Schablone für ätztechnische Oberflächenstrukturierungen weisen mindestens einen Matrixdruckkopf und mindestens eine Aufnahme für einen Schablonenträger auf, wobei der Matrixdruckkopf eine Schablonenschicht auf den Schablonenträger druckt. Zur Herstellung der Schablonenschicht werden dabei verschiedene Materialien eingesetzt. Bekannt ist beispielsweise der Einsatz von UV-härtender Tinte oder von Wachs.

Wie bereits erläutert, sind Verfahren zur ätztechnischen Oberflächenstrukturierung bekannt, bei welchen eine Schablonenschicht von einem Schablonenträger auf die zu strukturierende Oberfläche übertragen wird und die zu strukturierende Oberfläche bei aufgebrachter Schablonenschicht einer ätztechnischen Behandlung unterworfen wird.

Aus der US 2003/0034328 A1 ist es bekannt, Schablonen auf einen Papierträger aufzudrucken, diesen auf eine zu strukturierende Oberfläche aufzulegen und durch ein Erhitzen zu übertragen. Der Papierträger kann abgelöst und anschließend ein Ätzvorgang der Oberfläche vorgenommen werden. Dieser Vorgang kann für eine weitere Strukturierung wiederholt werden.

Die JP S57-169090 A betrifft ein Verfahren zur ätztechnischen Strukturierung einer Oberfläche, bei dem eine zweischichtige Maske in einem zweistufigen Ätzverfahren verwendet wird. In der JP S58-203054 A wird ein mehrstufiges Ätzverfahren zur Strukturierung einer Oberfläche angegeben.

Die DE 2 133 230 A beschreibt ein Verfahren zur Oberflächenstrukturierung, welches das Aufbringen einer zu belichtenden fotosensitiven Schicht umfasst. Die DE 10 2006 022 722 A1 betrifft ein Verfahren zur Herstellung eines Blechs oder Bands mit einer durch eine Maske eingebrachten Oberflächenstruktur. Die Maske enthält einen UVaushärtbaren Lack.

In der US 4,648,174 A wird ein Verfahren zur Dotierung eines Halbleiterelements offenbart, wobei verschiedene Maskenzonen mit unterschiedlicher Dichte aufgebracht werden. Die WO 98/02924 A beschreibt die Herstellung eines pn-Übergangs in einem Halbleiterelement, wobei eine Maske verwendet wird, welche sukzessiv weggeätzt werden kann. Alternativ können auch mehrere Masken eingesetzt werden.

In der GB 375,774 A wird ein Druckverfahren zur Reproduktion eines Natursteinmusters, beispielsweise der Oberfläche von Marmor, offenbart. Verschiedene Lösungsmittel werden verwendet, um die Oberfläche des Steins zu strukturieren.

Die US 2007/0128748 A1 betrifft die Oberflächenstrukturierung einer Masterplatte zum Einprägen oder Stempeln eines optisch variablen Sicherheitsmerkmals. Mehrere fotosensitive Schichten können aufgebracht werden, um eine dreidimensional strukturierte Maske zu erhalten.

Die US 2013/0286439 A1 offenbart einen Drucker für zumindest drei verschiedene Farben. Mindestens ein Druckkopf ist vorgesehen, welcher mindestens zwei verschiedenen Tinten für jede Farbe aufbringen kann. Ein weiterer Drucker mit mehreren Druckzonen ist aus der EP 1004 440 A2 bekannt.

Der vorliegenden Erfindung liegt die Aufgabe zugrunde, die bekannten Schablonen für ätztechnische Oberflächenstrukturierungen, die bekannten Verfahren zur Herstellung einer Schablone für ätztechnische Oberflächenstrukturierungen, die bekannten Druckmaschinen zur Herstellung einer Schablone für ätztechnische Oberflächenstrukturierungen sowie die bekannten Verfahren zur ätztechnischen Oberflächenstrukturierung dahingehend auszugestalten und weiterzubilden, dass anspruchsvolle, mehrschrittige Oberflächenstrukturierungen bei denen mindestens zwei ätztechnische Behandlungen aufeinanderfolgen, wesentlich vereinfacht und beschleunigt werden.

Gemäß einer ersten Lehre der Erfindung sind die bekannten Schablonen für ätztechnische Oberflächenstrukturierungen erfindungsgemäß dadurch ausgestaltet und weitergebildet, dass die Schablonenschicht mindestens zwei Teilbereiche aufweist und dass mindestens zwei Teilbereiche unabhängig voneinander von der zu strukturierenden Oberfläche entfernbare Schablonenmaterialien aufweisen. Dadurch, dass mindestens ein Teilbereich der erfindungsgemäßen Schablonenschicht unabhängig von einem anderen Teilbereich der erfindungsgemäßen Schablonenschicht von der zu strukturierenden Oberfläche entfernbar ist, ist gewährleistet, dass nach einmaligem Übertrag der erfindungsgemäßen Schablonenschicht auf die zu strukturierende Oberfläche eine zwei- oder mehrstufige ätztechnische Behandlung erfolgen kann.

Dabei werden zwischen zwei ätztechnischen Behandlungen mindestens ein Teilbereich der Schablonenschicht von der zu strukturierenden Oberfläche, zum Beispiel durch Einsatz selektiver Lösungsmittel, entfernt. Die erfindungsgemäße Ausgestaltung der Schablone ermöglicht also eine mehrstufige Strukturierung zur Herstellung anspruchsvoller Strukturbilder ohne dass in jedem Schritt eine neue Schablonenschicht auf die weiter zu strukturierende Oberfläche übertragen werden muss. Der auf der zu strukturierenden Oberfläche verleibende Teilbereich der Schablonenschicht deckt bei der folgenden ätztechnischen Behandlung weiterhin Teilbereiche der zu strukturierenden Oberfläche ab und ermöglicht so die Herstellung anspruchsvoller Strukturbilder.

Die erste Lehre der Erfindung erfährt eine vorteilhafte Ausgestaltung dadurch, dass ein Teilbereich der Schablonenschicht eine UV-härtbare Tinte aufweist. Der Einsatz UV-härtbarer Tinten zur Herstellung von Schablonen für ätztechnische Oberflächenstrukturierungen ist bekannt und erprobt. Auch die Verfahren zur Entfernung ausgehärteter UV-härtbarer Tinten von den zu strukturierenden Oberflächen sind erprobt.

Der Einsatz von UV-härtbaren Tinten zur Herstellung eines ersten Teilbereiches einer erfindungsgemäß ausgestalteten Schablonenschicht lässt sich besonders vorteilhaft damit kombinieren, dass ein Teilbereich der Schablonenschicht eine pastöse Tinte aufweist. Die Lösungsmittelsysteme, die zum Ablösen einer ausgehärteten UV-härtbaren Tinte eingesetzt werden greifen die eine pastöse Tinte aufweisenden Teilbereiche nicht an. Demzufolge lassen sich zwei Teilbereiche, die einerseits aus einer UV-härtbaren Tinte und andererseits aus einer pastösen Tinte bestehen unabhängig voneinander von der zu strukturierenden Oberfläche entfernen.

Die Verfahren zur Herstellung einer erfindungsgemäßen Schablone für ätztechnische Oberflächenstrukturierungen werden gemäß einer zweiten Lehre der Erfindung dadurch ausgestaltet, dass in mindestens zwei Teilbereichen der Schablonenschicht mit Hilfe eines Matrixdruckers unabhängig voneinander von der zu strukturierenden Oberfläche entfernbare Schablonenmaterialien aufgebracht werden. Zu den Vorteilen dieser erfindungsgemäßen Ausgestaltung wird auf die in Verbindung mit der erfindungsgemäßen Ausgestaltung einer Schablone für ätztechnische Oberflächenstrukturierungen beschriebenen Vorteile verwiesen.

Die Druckmaschinen zur Herstellung einer erfindungsgemäßen Schablone für ätztechnische Oberflächenstrukturierungen werden gemäß einer dritten Lehre der Erfindung dadurch ausgestaltet, dass der mindestens eine Matrixdruckkopf Zuführungen für mindestens zwei unabhängig voneinander von der zu strukturierenden Oberfläche entfernbare Schablonenmaterialien aufweist. Der Einsatz eines oder mehrerer Matrixdruckköpfe, die gleichzeitig oder nacheinander in Teilbereichen der Schablonenschicht mindestens zwei unabhängig voneinander von der zu strukturierenden Oberfläche entfernbare Schablonenmaterialien drucken, ermöglicht eine einfache EDV-gestützte Herstellung der gewünschten Schablonen für ätztechnische Oberflächenstrukturierungen.

Schließlich wird gemäß einer vierten Lehre der Erfindung ein bekanntes Verfahren zur ätztechnischen Oberflächenstrukturierungen unter Verwendung einer erfindungsgemäßen Schablone dadurch ausgestaltet und weitergebildet, dass nach einer ersten ätztechnischen Behandlung ein Teilbereich der Schablonenschicht entfernt wird und die zu strukturierende Oberfläche mindestens einer zweiten ätztechnischen Behandlung unterworfen wird. Zu den mit dieser Ausgestaltung verbundenen Vorteile wird auf die in Verbindung mit der ersten Lehre der Erfindung geschilderten Vorteile verwiesen.

Ein gemäß der vierten Lehre der Erfindung ausgestaltetes Verfahren zur ätztechnischen Oberflächenstrukturierung wird dadurch weiter ausgestaltet, dass nach einer ätztechnischen Behandlung ein eine UV-härtende Tinte aufweisender Teilbereich der Schablonenschicht mit Hilfe von Natronlauge entfernt wird. Natronlauge stellt ein Lösungsmittelsystem dar, welches zur Entfernung ausgehärteter UV-härtender Tinte geeignet ist.

Gemäß einer zweiten Ausgestaltung der vierten Lehre der Erfindung wird nach einer ätztechnischen Behandlung ein eine pastöse Tinte aufweisender Teilbereich der Schablonenschicht mit Hilfe von Ethylacetat entfernt. Während Natronlauge UV-härtende Tinte entfernt, greift diese Natronlauge eine pastöse Tinte nicht an. Die pastöse Tinte kann im Fall einer zweischrittigen ätztechnischen Behandlung abschließend mit Hilfe von Ethylacetat entfernt werden.

Es gibt eine Vielzahl von Möglichkeiten und Ausgestaltungen der erfindungsgemäßen Lehren zur Verbesserung einer Schablone für ätztechnische Oberflächenstrukturierungen, eines Verfahrens zur Herstellung einer Schablone für ätztechnische Oberflächenstrukturierungen, einer Druckmaschine zur Herstellung einer Schablone für ätztechnische Oberflächenstrukturierungen sowie eines Verfahrens zur ätztechnischen Oberflächenstrukturierung.

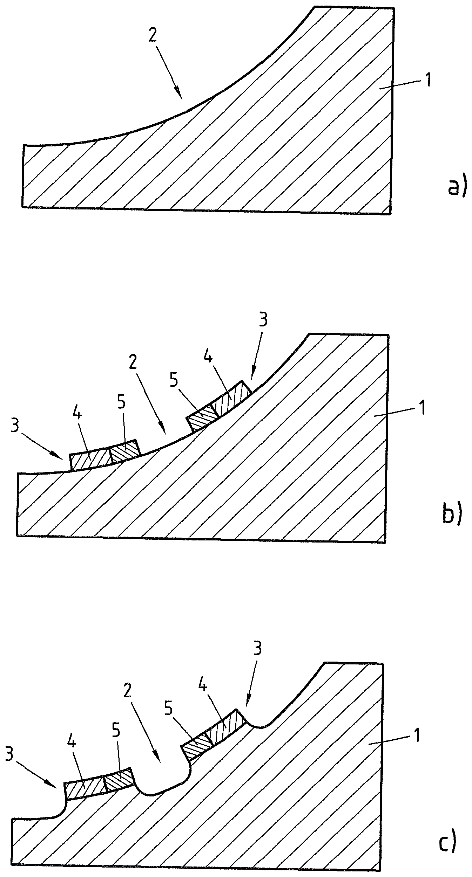

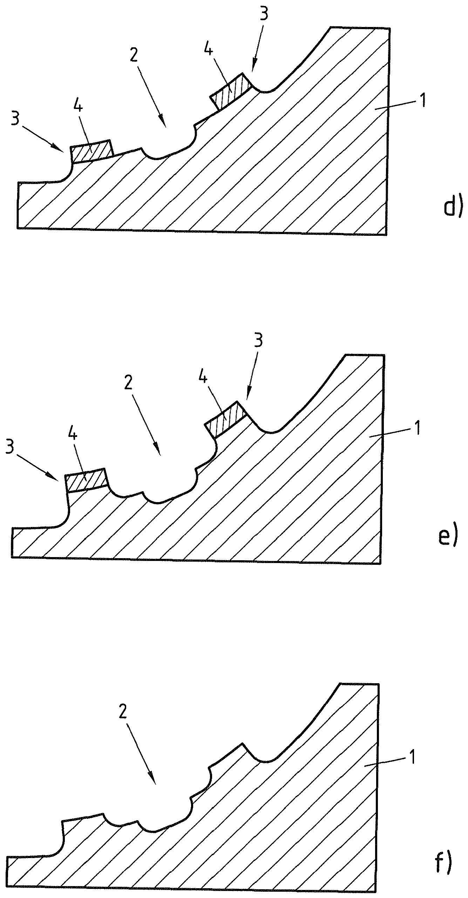

Die einzige Figur der Zeichnung zeigt beispielhaft eine ätztechnische Oberflächenstrukturierung unter Verwendung einer erfindungsgemäß ausgestalteten Schablone.

In a) zeigt die einzige Figur ein unbehandeltes Werkstück 1 mit einer zu strukturierenden Oberfläche 2. Auf die zu strukturierende Oberfläche wird, wie in b) dargestellt, eine Schablonenschicht 3 übertragen, welche erfindungsgemäß zwei Teilbereiche, nämlich einen ersten Teilbereich 4 und einen zweiten Teilbereich 5 aufweist.

In einem nächsten Schritt wird die zu strukturierende Oberfläche 2 einer ätztechnischen Behandlung unterzogen, wodurch die Oberfläche 2, wie aus c) der einzigen Figur ersichtlich, in den nicht von der Schablonenschicht 3 abgedeckten Bereichen abgetragen, also strukturiert, wird. Da sowohl der erste Teilbereich 4 als auch der zweite Teilbereich 5 der Schablonenschicht 3 ätzresistent sind, werden diese durch die ätztechnischen Behandlungen nicht entfernt.

In einem nächsten Schritt erfolgt eine Behandlung zumindest der Schablonenschicht 3 bei dem dargestellten Ausführungsbeispiel mit Natronlauge. Dadurch, dass bei dem dargestellten Ausführungsbeispiel der zweite Teilbereich 5 im Wesentlichen aus einer UV-Tinte besteht, wird dieser zweite Teilbereich 5 durch die Behandlung mit Natronlauge entfernt. Das Ergebnis ist in d) der einzigen Figur dargestellt.

In e) der einzigen Figur ist die Struktur der Oberfläche 2 des Werkstückes 1 nach einer zweiten ätztechnischen Behandlung, während der lediglich der erste Teilbereich 4 der Schablonenschicht auf der Oberfläche 2 verblieben ist, dargestellt.

Im letzten Teilbild f) der einzigen Figur ist schließlich das resultierende Werkstück 1 mit einer strukturierten Oberfläche 2 nach Entfernen des ersten Teilbereiches 4 der Schablonenschicht 3 dargestellt. Bei dem hier beschriebenen Ausführungsbeispiel besteht der erste Teilbereich 4 der Schablonenschicht 3 im Wesentlichen aus einer pastösen Tinte, die im hier abschließenden Schritt mit Ethylacetat entfernt worden ist.

Dem Teilbild f) kann man entnehmen, dass es mit einer erfindungsgemäß ausgestalteten Schablone bei nur einmaliger Übertragung einer Schablonenschicht 3, welche zwei Teilbereiche 4, 5 aufweist, auf das Werkstück 2 gelingt, eine komplexe Oberflächenstrukturierung durch ätztechnische Behandlungen zu gewährleisten. Hierzu muss erfindungsgemäß eine Schablonenschicht 3 nur einmal auf die zu strukturierende Oberfläche 2 des Werkstückes 1 übertragen werden. Nach einer ersten ätztechnischen Behandlung wird der zweite Teilbereich 5 der Schablonenschicht entfernt und eine weitere ätztechnische Behandlung durchgeführt, welche nun auch auf die Bereiche der Oberfläche 2 einwirkt, die vorher durch den zweiten Teilbereich 5 der Schablonenschicht 3 abgedeckt waren. Schließlich wird auch der erste Teilbereich 4 der Schablonenschicht 3 von dem Werkstück 1 entfernt.

Eine erfindungsgemäße Schablonenschicht kann zwei oder mehr Teilbereiche aufweisen. Auch ist es möglich, besonders kompliziert zu strukturierende Oberflächen zwei- oder mehrfach mit erfindungsgemäß ausgestalteten Schablonen zu bearbeiten.

## Patentansprüche

1. Schablone für ätztechnische Oberflächenstrukturierungen, mit einer ätzresistenten Schablonenschicht (3), wobei die Schablonenschicht (3) auf die zu strukturierende Oberfläche (2) durch Abreiben übertragbar ist und wobei die Schablonenschicht (3) nach einer ätztechnischen Behandlung der zu strukturierenden Oberfläche (2) zumindest teilweise entfernbar ist,
**dadurch gekennzeichnet, dass**
die Schablonenschicht (3) mindestens zwei Teilbereiche (4, 5) aufweist und dass mindestens zwei Teilbereiche (4, 5) unabhängig voneinander von der zu strukturierenden Oberfläche (2) entfernbare Schablonenmaterialien aufweisen.

2. Schablone nach Anspruch 1,
**dadurch gekennzeichnet, dass**
ein Teilbereich (5) der Schablonenschicht eine UV-härtbare Tinte aufweist.

3. Schablone nach Anspruch 1 oder 2,
**dadurch gekennzeichnet, dass**
ein Teilbereich der Schablonenschicht (4) eine pastöse Tinte aufweist.

4. Verfahren zur Herstellung einer Schablone für ätztechnische Oberflächenstrukturierungen nach einem der Ansprüche 1 bis 3, bei welchem eine ätzresistente Schablonenschicht mit Hilfe eines Matrixdruckers auf einen Schablonenträger aufgebracht wird,
**dadurch gekennzeichnet, dass**
in mindestens zwei Teilbereichen der Schablonenschicht mit Hilfe eines Matrixdruckers unabhängig voneinander von der zu strukturierenden Oberfläche entfernbare Schablonenmaterialien aufgebracht werden.

5. Druckmaschine zur Herstellung einer Schablone für ätztechnische Oberflächenstrukturierungen nach einem der Ansprüche 1 bis 3, mit mindestens einem Matrixdruckkopf und mindestens einer Aufnahme für einen Schablonenträger, wobei der Matrixdruckkopf dafür eingerichtet ist, eine Schablonenschicht auf den Schablonenträger zu drucken,
**dadurch gekennzeichnet, dass**
der mindestens eine Matrixdruckkopf Zuführungen für mindestens zwei unabhängig voneinander von der zu strukturierenden Oberfläche entfernbare Schablonenmaterialien aufweist.

6. Verfahren zur ätztechnischen Oberflächenstrukturierung unter Verwendung einer Schablone nach einem der Ansprüche 1 bis 3, bei welchem eine Schablonenschicht von einem Schablonenträger durch Abreiben auf die zu strukturierende Oberfläche übertragen wird und die zu strukturierende Oberfläche bei aufgebrachter Schablonenschicht einer ätztechnischen Behandlung unterworfen wird,
**dadurch gekennzeichnet, dass**
nach einer ersten ätztechnischen Behandlung ein Teilbereich der Schablonenschicht entfernt wird und die zu strukturierende Oberfläche mindestens einer zweiten ätztechnischen Behandlung unterworfen wird.

7. Verfahren nach Anspruch 6,
**dadurch gekennzeichnet, dass**
nach einer ätztechnischen Behandlung ein eine UV-härtende Tinte aufweisender Teilbereich der Schablonenschicht mit Hilfe von Natronlauge entfernt wird.

8. Verfahren nach Anspruch 6 oder 7,
**dadurch gekennzeichnet, dass**
nach einer ätztechnischen Behandlung ein eine pastöse Tinte aufweisender Teilbereich der Schablonenschicht mit Hilfe von Ethylacetat entfernt wird.

## Claims

1. Stencil for etched surface structurings, with an etch-resistant stencil layer (3) wherein the stencil layer (3) can be transferred to the structuring surface (2) by rubbing and wherein the stencil layer (3), after etching treatment of the surface (2) to be structured, is at least partially removable, **characterised in that**
the stencil layer (3) comprises at least two partial sections (4, 5) and **in that** at least two partial sections (4, 5) have stencil materials that are removable independently of each other from the surface (2) to be structured.

2. Stencil according to claim 1,
**characterised in that**
a partial section (5) of the stencil layer has a UV-hardenable ink

3. Stencil according to claim 1 or 2,
**characterised in that**
one partial section of the stencil layer (4) comprises a pasty ink.

4. Method of producing a stencil for etched surface structurings according to any one of claims 1 to 3, wherein an etch-resistant stencil layer is applied to a stencil carrier by means of a matrix printer, **characterised in that**
in at least two partial sections of the stencil layer, stencil materials that are removable independently of each other from the surface to be structured are applied by means of a matrix printer.

5. Printing machine for producing a stencil for etched surface structurings according to any one of claims 1 to 3 with at least one matrix print head and at least one holder for a stencil carrier, wherein the matrix print head is configured to print a stencil layer on the stencil carrier,
**characterised in that**
the at least one matrix print head has feeders for at least two stencil materials that can be removed independently of each other from the surface to be structured.

6. Method of etched surface structuring using a stencil according to any one of claims 1 to 3 in which a stencil layer is transferred from one stencil carrier by rubbing onto the surface to be structured, and with the stencil layer applied, the surface to be structured undergoes etching treatment,
**characterised in that**
after a first etching treatment a partial section of the stencil layer is removed and the surface to be structured undergoes at least a second etching treatment.

7. The method according to claim 6,
**characterised in that**
after an etching treatment, a partial section of the stencil layer comprising a UV-hardening ink is removed by means of sodium hydroxide solution.

8. The method according to claim 6 or 7,
**characterised in that**
after an etching treatment, a partial section of the stencil layer comprising a pasty ink is removed by means of ethyl acetate.

## Revendications

1. Pochoir pour structurations de surface par technologie de gravure, comportant une couche de pochoir (3) résistant à l'attaque de la gravure, la couche de pochoir (3) étant transférable sur la surface à structurer (2) par érosion et la couche de pochoir (3) pouvant être éliminée du moins partiellement de la surface à structurer (2) après traitement par technologie de gravure,
**caractérisé en ce que**
la couche de pochoir (3) présente au moins deux sous-zones (4, 5) et qu'au moins deux sous-zones (4, 5) présentent des matériaux de pochoir pouvant être éliminés indépendamment les uns des autres de la surface à structurer (2).

2. Pochoir selon la revendication 1,
**caractérisé en ce**
**qu'**une sous-zone (5) de la couche de pochoir présente une encre durcissable aux UV.

3. Pochoir selon la revendication 1 ou 2,
**caractérisé en ce que**
qu'une sous-zone de la couche de pochoir (4) présente une encre pâteuse.

4. Procédé de fabrication d'un pochoir pour structurations de surface par technologie de gravure selon une des revendications 1 à 3, dans lequel une couche de pochoir résistant à la gravure est appliquée à l'aide d'une imprimante matricielle sur un support de pochoir,
**caractérisé en ce que**,
dans au moins deux sous-zones de la couche de pochoir, des matériaux de pochoir pouvant être éliminés sont appliqués indépendamment les uns des autres sur la surface à structurer à l'aide d'une imprimante matricielle.

5. Machine d'impression pour la fabrication d'un pochoir pour structurations de surface par technologie de gravure selon une des revendications 1 à 3, comportant au moins une tête d'impression matricielle et au moins un support pour un support de pochoir, la tête d'impression matricielle étant conçue pour imprimer une couche de pochoir sur le support de pochoir,
**caractérisée en ce que**
l'au moins une tête d'impression matricielle présente des conduites d'acheminement pour au moins deux matériaux de pochoir pouvant être éliminés indépendamment les uns des autres de la surface à structurer.

6. Procédé pour la structuration de surface par technologie de gravure en utilisant un pochoir selon une des revendications 1 à 3, dans lequel une couche de pochoir est transférée par un support de pochoir par érosion sur la surface à structurer et la surface à structurer est soumise à un traitement par technologie de gravure une fois que la couche de pochoir est appliquée,
**caractérisé en ce que**,
après un premier traitement par technologie de gravure, une sous-zone de la couche de pochoir est éliminée et la surface à structurer est soumise à au moins un second traitement par technologie de gravure.

7. Procédé selon la revendication 6,
**caractérisé en ce que**,
après un traitement par technologie de gravure, une sous-zone présentant une encre durcissant aux UV de la couche de pochoir est éliminée à l'aide de soude caustique.

8. Procédé selon la revendication 6 ou 7,
**caractérisé en ce que**
après un traitement par technologie de gravure, une sous-zone présentant une encre pâteuse de la couche de pochoir est éliminée à l'aide d'acétate d'éthyle.
